# FASCICULE DE BREVET EUROPEEN

(11) **EP 0 446 125 B1**
(45) Date de publication et mention de la délivrance du brevet: **10.05.1995**
(21) Numéro de dépôt: 91400597.0
(22) Date de dépôt: 05.03.1991
(51) Int. Cl.: H01L 23/367, H01L 23/482, H01L 23/522, H01L 23/66

(54) **Composant semi-conducteur de puissance**
Leistungshalbleiteranordnung
Power semiconductor device

(30) Priorité: 09.03.1990 FR 9003036
(43) Date de publication de la demande: 11.09.1991
(73) Titulaire: THOMSON-CSF SEMICONDUCTEURS SPECIFIQUES, 92800 Puteaux (FR)
(72) Inventeur: Legros, Patrick, F-92045 Paris la Défense (FR)
(74) Mandataire: Guérin, Michel

(56) Documents cités:
- EP-A- 0 166 633
- EP-A- 0 334 747
- FR-A- 2 554 275
- US-A- 3 675 089
- PATENT ABSTRACTS OF JAPAN vol. 12, no. 403 (E-674)(3250), 26 octobre 1988; & JP-A-63144588
- PATENT ABSTRACTS OF JAPAN vol. 5, no. 145 (E-74)(817), 12 septembre 1981; & JP - A - 56080164 81
- IBM TECHNICAL DISCLOSURE BULLETIN vol. 21, no. 11, avril 1979, page 4494, New York, US; E. BERNDLMAIER: "Dummy pads for reduced thermal resistancealresistance"

## Description

La présente invention concerne un dispositif semiconducteur, comportant au moins un transistor de puissance interdigité, dont la puce est montée à l'envers, c'est à dire par sa face active, sur une embase qui sert de dissipateur thermique. Le montage peut être effectué de telle façon que la puce soit auto encapsulée.

On sait que dans un dispositif semiconducteur, la partie active se trouve sur une première face de la puce, et qu'elle est d'épaisseur de l'ordre de 1 à 10 micromètres, tandis que le substrat a une épaisseur de l'ordre de 300 à 500 micromètres. Cependant, en cours de fonctionnement, la chaleur est produite par la partie active, et elle doit traverser tout le substrat pour être évacuée par la deuxième face du substrat, au moyen d'un dissipateur thermique.

Le problème existe pour les semiconducteurs sur substrat silicium, qui a cependant d'assez bonnes qualités de conductibilité thermique, mais il est aggravé pour les semiconducteurs sur substrats en matériaux III-V tel que GaAs, qui est un très mauvais conducteur thermique , et il devient très préoccupant dans le cas des semiconducteurs de puissance qui dissipent beaucoup de chaleur.

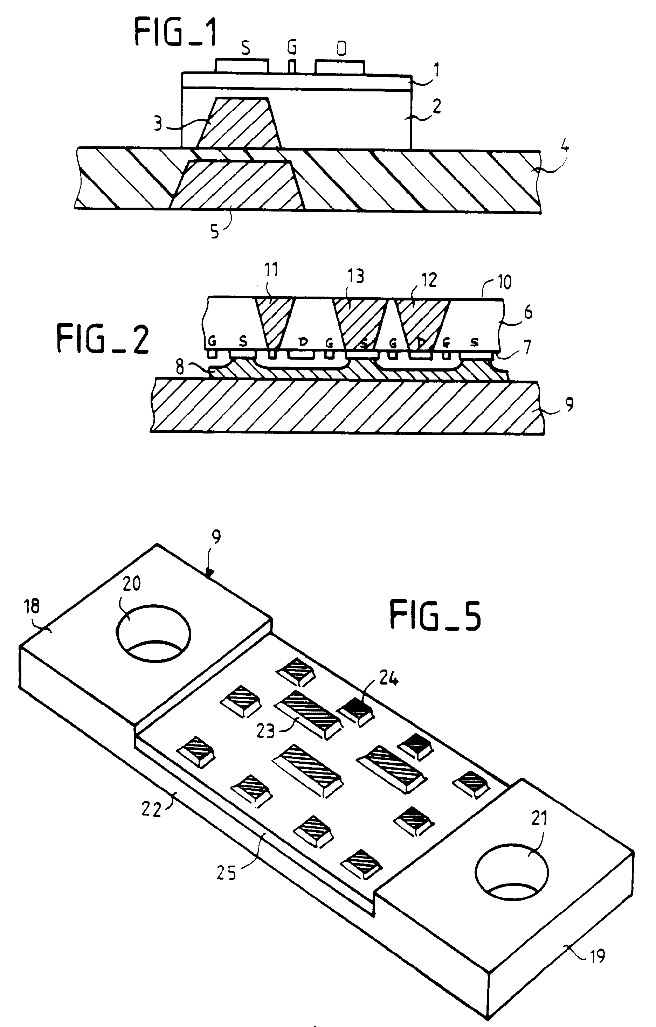

Les solutions actuelles sont délicates et onéreuses à mettre en oeuvre. Parmi de nombreuses possibilités on peut citer :
- l'amincissement du substrat, par sa face arrière, pour diminuer la longueur du transfert thermique. Mais ce procédé fragilise la puce, surtout s'il s'agit d'un circuit de grandes dimensions,
- l'implantation d'un drain thermique dans le substrat, tel que représenté en figure 1. Si l'on considère un semiconducteur réduit à une couche active 1 supportée par un substrat 2, on peut graver une cavité dans le substrat 2, jusqu'à proximité de la région la plus chaude de la couche active 1, et remplir cette cavité d'un métal, ce qui en fait un drain thermique 3, en contact avec un dissipateur 4. Mais cette technique est délicate
- si l'embase 4 est elle même un isolant thermique, par exemple une plaque d'alumine dans un circuit hybride, on peut la transformer de façon analogue à la précédente, en l'incrustant de régions métalliques 5 qui améliorent le coefficient de transfert thermique, comme représenté sur la figure 1.

Ces différentes solutions ont en outre le désavantage de présenter une suite de jonctions entre matériaux mauvais conducteurs thermiques et matériaux bons conducteurs thermiques, ce qui ne constitue pas une optimisation.

Il est connu de monter une puce semiconductrice à l'envers, selon la technologie dite "flip-chip", soit sur un radiateur, soit sur un substrat isolant sur lequel sont disposées des pistes conductrices. En effet, toute la chaleur dégagée en fonctionnement par un dispositif semiconducteur provient de la face supérieure de la puce, opposée à la face arrière, et un montage à l'envers assure un contact direct, en évitant le transfert de la chaleur à travers l'épaisseur du substrat. Le brevet européen EP-A- O 166 633 présente un exemple de montage à l'envers, pour une puce de semiconducteur qui ne comprend pas de ponts à air, c'est à dire de ponts métalliques qui, passant par dessus une région d'un dispositif semiconducteur, laissent un espace d'air entre lui et la face supérieure du dit dispositif. Dans le brevet cité, des métallisations de différentes épaisseurs permettent de ne pas court-circuiter les différentes électrodes, et de réaliser l'encapsulation d'un transistor hyperfréquence de moyenne puissance, fonctionnant à 10 GHz au moins, pour lequel on ne sait pas réaliser un boîtier classique.

L'invention s'applique aux transistors de forte puissance, munis de "ponts à air".

L'invention propose de dissiper la chaleur dégagée en fonctionnement par un contact direct entre la couche active du dispositif semiconducteur et un radiateur thermique, en brasant la puce "à l'envers" sur le radiateur.

Toutefois, afin de ne pas court-circuiter les métallisations des différentes électrodes du dispositif semiconducteur, par exemple source, grille et drain d'un transistor à effet de champ, les électrodes d'un même type, par exemple la source, et qui sont à un même potentiel sont réunies entre elles par des ponts métalliques, dits ponts "à air", renforcés par une surépaisseur afin de leur donner la résistance mécanique suffisante. L'invention s'applique donc à un circuit électronique qui comprend au moins un transistor de puissance, lui-même interdigité, comportant au moins deux doigts d'une même électrode pour permettre d'établir entre elles un pont métallique.

De façon plus précise, l'invention concerne un composant semiconducteur de puissance, constitué par une puce semiconductrice et un radiateur thermique, le dispositif semiconducteur porté par une première face de la puce comportant au moins une métallisation d'électrode interdigitée à au moins deux doigts, réunis entre eux par au moins un pont métallique, dit "pont à air" dont l'espace d'air le sépare de la première face de la puce semiconductrice, ce composant étant caractérisé en ce que :
- en vue de transférer la chaleur dégagée en cours de fonctionnement vers le radiateur, la puce est brasée à l'envers sur le radiateur par l'intermédiaire d'au moins un pont à air servant de drain thermique,
- la fixation mécanique de la puce sur le radiateur est en outre assurée par une pluralité de métallisations, disposées sur le pourtour de la puce, et brasées sur le radiateur.

L'invention sera mieux comprise et ses avantages ressortiront mieux grâce à la description détaillée qui suit maintenant, et qui s'appuie sur les figures jointes en annexe, qui représentent :
- figure 1 : vue en coupe d'un transistor monté selon l'art connu, exposée précédemment,
- figure 2 : vue en coupe d'un transistor monté sur un radiateur, selon l'invention,
- figure 3 : vue de 3/4 dans l'espace de la puce d'un circuit semiconducteur, modifié selon l'invention
- figure 4 : vue de 3/4 dans l'espace de l'embase métallique, radiateur de la puce de la figure précédente, selon l'invention,
- figure 5 : vue de 3/4 dans l'espace de l'embase selon l'invention dans une variante de réalisation
- figure 6 : vue en plan d'un circuit selon l'invention comportant des composants annexes.

La figure 2 représente la coupe d'un fragment de dispositif semiconducteur monté sur un radiateur, selon l'invention. En vue de simplifier la figure, une partie seulement d'un transistor de puissance est représentée, mais il est bien entendu que l'invention s'applique également au cas d'un circuit intégré comportant plusieurs transistors, ou aux transistors bipolaires.

Considérons le cas le plus défavorable du point de vue thermique : celui d'un transistor hyperfréquence en GaAs ou matériaux du groupe III-V. Sa puce 6 est donc en GaAs, et elle comporte sur une première face 7 une série de métallisations qui correspondent aux électrodes des diverses régions -non représentées- de source, grille et drain -ou d'émetteur, base, collecteur s'il s'agit d'un transistor bipolaire-.

Pour obtenir une puissance suffisante, les transistors hyperfréquences de puissance sont pratiquement tous constitués par une pluralité de transistors de faible puissance, montés en parallèle. Leur association peut prendre différentes formes géométriques, la plus courante étant la forme interdigitée selon laquelle les métallisations de source, grille et drain d'un même transistor forment un peigne de bandes métalliques parallèles.

Toutes les métallisations d'un premier type -par exemple la grille- sont réunies par un bus, situé d'un premier côté du peigne, et toutes les métallisations d'un second type -par exemple le drain- sont réunies par un autre bus situé d'un second côté du peigne. Pour réunir les métallisations d'un troisième type- la source en l'occurrence- il est nécessaire, puisqu'il n'y a que deux dimensions dans un plan, d'utiliser une troisième dimension : les ponts à air, ainsi nommés parce que ce sont les ponts métalliques qui laissent un espace d'air entre eux et la puce semiconductrice.

Selon l'invention, ces ponts à air 8 sont rechargés en métal par électrolyse, jusqu'à atteindre une épaisseur de l'ordre de 3 micromètres pour les travées de pont et de l'ordre de 4 micromètres pour les piles de pont. Cette épaisseur est suffisante pour assurer une bonne conductivité thermique et évacuer la chaleur dégagée par la source du transistor vers un radiateur.

La puce du dispositif semiconducteur étant ainsi modifiée par épaississement des ponts à air, elle est brasée ou soudée sur un radiateur 9, non plus par la seconde face 10 - côté substrat- de la puce, comme dans l'art connu, mais par ses ponts à air 8. La chaleur dégagée au niveau de la première face 7, en cours de fonctionnement, passe directement des régions chaudes au radiateur 9 : le trajet thermique est très court, et le seul interface entre régions chaudes et froides est un pont métallique, de bonne conductibilité thermique, puisque les ponts à air sont généralement réalisés en or.

Puisque la puce est montée à l'envers sur un radiateur 9, l'accès aux électrodes est obtenu par des trous métallisés, ou "via holes", à travers le substrat de la puce. Au moins un trou métallisé 11 sur le bus de grille et au moins un trou métallisé 12 sur le bus de drain ramènent les prises de contact de grille et drain sur la seconde face 10, accessible, de la puce 6.

La prise de contact électrique de source peut être prise sur le radiateur 9, s'il est métallique, mais il est préférable de prévoir également un trou métallisé 13 pour la source. Cela permet de tester sous pointes le dispositif achevé : ainsi, dans un appareil de test électrique sous pointes, les pointes travaillent toutes dans un même plan.

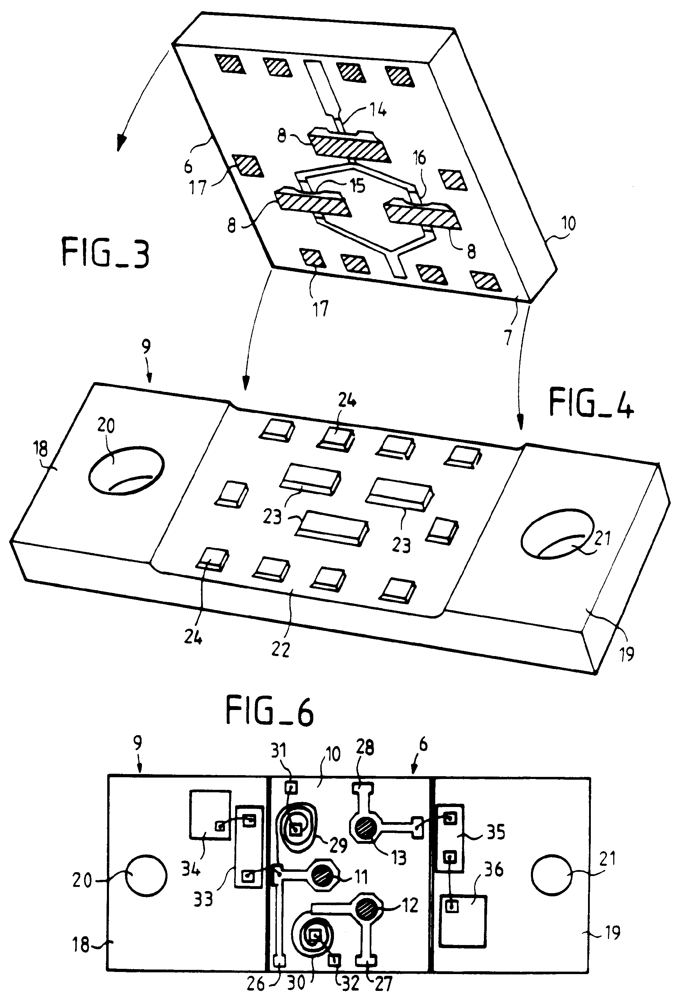

Le montage d'une puce 6 sur un radiateur 9 nécessite en outre l'aménagement de moyens de contacts qui ressortent mieux sur les figures 3 et 4.

Les figures 3 et 4 doivent être considérées simultanément, la figure 3 représentant, vu de 3/4 par des sous, la puce de semiconducteur 6 qui doit être brasée sur le radiateur 9, vu de 3/4 par dessus, de la figure 4.

Sur la figure 3 est représenté un circuit intégré qui est simplifié à l'extrême : tout ce qui n'est pas indispensable à la compréhension n'est pas représenté. Le schéma indique que c'est, à titre d'exemple, un amplificateur de structure arborescente, comportant un étage d'entrée constitué par un transistor de puissance 14, et un étage de sortie constitué par deux transistors de puissance 15 et 16 en parallèle.

Ces trois transistors de puissance sont interdigités et munis, sur leurs sources par exemple - parce que ce sont les sources qui dégagent le plus de chaleur dans un transistor à effet de champ- de ponts à air 8. Ces ponts à air ont des dimensions maximales, compte tenu de la géométrie de surface du circuit, de façon à abaisser l'impédance thermique.

En vue d'éviter que la puce de semiconducteur 6 ne soit brasée sur le radiateur 9 uniquement par les ponts à air 8, trop fragiles, il est prévu de disposer sur le pourtour de la puce, sur sa face 7, une pluralité de plots métallisés 17 : ce sont eux qui supportent l'effort mécanique dans l'association brasée puce/radiateur, tandis que les ponts à air 8 ne servent qu'au transfert thermique.

Le radiateur 9 peut prendre différentes configurations et être réalisé en différents matériaux à bonne conductibilité thermique. Il peut être métallique et avoir une forme homothétique de celle de la puce de semiconducteur 6, mais il est avantageusement d'une forme telle que celle représentée en figure 4.

C'est un rectangle de métal, par exemple en cuivre doré, nickelé ou étamé, assez épais pour avoir une masse calorifique importante. Ses deux extrêmités opposées 18 et 19 comportent chacune un trou 20 et 21 et constituent ainsi une patte de fixation du dispositif achevé. La partie centrale 22 est en léger retrait par rapport à une face principale du radiateur. Elle comporte deux séries d'ilôts en relief. Les ilôts 23 de la première série ont une hauteur et une position bien déterminées, pour qu'ils correspondent aux ponts à air 8 de la puce 6. Les ilôts 24 de la deuxième série ont une position en relation avec les plôts métallisés 17 de la puce 6, et une hauteur légèrement plus importante que celle des ilôts 23, afin d'éviter que les ponts à air 8 ne soient écrasés lorsque la puce 6 est brasée sur le radiateur 9. La hauteur d'un ilôt 24 est égale à la somme des hauteurs d'un ilôt 23 et d'un pont à air 8.

Les ilôts 23 et 24 peuvent être réalisés soit par matriçage de la plaque métallique, soit par gravure chimique, avec masquage adéquat. Lorsque les ilôts sont réalisés, ils reçoivent, sur leur face supérieure, une couche de brasure, soit par évaporation, soit par électrolyse, ces deux techniques nécessitant les masquages adéquats.

Il suffit de déposer la puce 6 à l'envers sur son radiateur 9, les parties à braser en semble étant parfaitement en regard, et de chauffer l'ensemble, pour que les ponts à air 8 et les plôts 17 soient brasés sur le radiateur 9. Dans ce cas de radiateur métallique, tous les ponts à air 8 sont au même potentiel, généralement la masse.

Mais il peut se présenter que, dans un circuit intégré, plusieurs régions chaudes soient à des potentiels différents : par exemple la source d'un premier transistor est à la masse et la source d'un deuxième transistor est à une tension de rappel. Un unique radiateur métallique, tel que celui de la figure 4, court-circuiterait ces potentiels et n'est donc pas utilisable.

Dans ce cas, la solution est apportée par un radiateur isolant électrique représenté en figure 5. Il comporte une embase métallique, munie de pattes de fixation 18/20 et 19/21 comparable à celle de la figure précédente, mais sa partie centrale 22 est plus profondément usinée, pour permettre d'y insérer une plaquette isolante 25, brasée par sa face arrière sur l'embase. Cette plaquette 25 peut être en oxyde de béryllium, en nitrure d'aluminium ou en diamant industriel, qui sont des isolants électriques réputés pour leur bonne conductibilité thermique.

Les ilôts 23 et 24 ont, comme précédemment, des positions et des hauteurs fixées par la géométrie de la puce de semiconducteur qui y est brasée. Ils peuvent être obtenus par gravure, mais ce procédé est long et côuteux avec les matériaux cités. Il est préférable de les obtenir par croissance électrolytique, à partir d'empreintes métallisées déposées par évaporation sur la plaquette isolante 25. Les ilôts 23 et 24 peuvent être consitutés soit par une première couche de métal sur laquelle est déposée une couche de brasure, soit, vu les épaisseurs en jeu, par une seule couche de brasure.

Un premier perfectionnement à l'invention consiste à multiplier les plots métallisés 17 et les ilôts 24 jusqu'à ce qu'ils constituent, respectivement, un cordon qui suit le pourtour de la puce 6 et un mur qui suit le contour de la partie centrale 22 du radiateur. Lorsque la puce 6 est brasée sur son radiateur 9, sa face active 7 est auto-encapsulée, et le substrat de la puce sert de couvercle à ce micro-boitier. Les moyens 17 et 24 de maintien mécanique sont devenus, en outre, les flancs du micro-boitier.

Un second perfectionnement est représenté en figure 6, qui représente une vue en plan d'une puce de semiconducteur montée sur un radiateur selon la technique de l'invention.

Puisque la puce de semiconducteur 6 est montée à l'envers sur son radiateur 9 qui lui sert d'embase, la face arrière 10 de la puce est libre d'accès, et elle comporte les trous métallisés 11,12,13 par lesquels on accède aux électrodes du dispositif, transistor ou circuit intégré. Le second perfectionnement proposé peut comporter plusieurs étapes.

La première consiste à réunir chaque trou métallisé à un plot de connexion externe situé sur le bord de la face arrière 10 de la puce. Dans l'exemple illustré, les trous métallisés 11,12,13 sont réunis, respectivement, aux plots 26,27,28. Pour que plusieurs dispositifs selon l'invention soient cascadables, il est avantageux que les plots d'accès extérieur soient disposés le long des deux bords de la puce quine sont pas en face d'une patte de fixation 18 et 19.

La seconde étape consiste à déposer directement sur la face 10 de la puce des composants non intégrables, à la seule condition que la puce soit d'une surface suffisante pour le permettre. A titre d'exemple, deux selfs 29 et 30 sont connectées sur les trous métallisés 11 et 12, sur la figure 6. Les composants rapportés sur la puce peuvent soit former un circuit, soit être reliés à des plots de connexions externes, tels que 31 et 32.

Enfin, l'invention prévoit de rapporter des composants non intégrables à l'extérieur de la puce 6, sur le radiateur 9 qui sert d'embase. A cette fin, les pattes de fixation 18 et 19 peuvent être, si nécessaire, modifiées ou agrandies, et des composants de préférence sous forme pavé, sont brasés sur les pattes de fixation 18 et 19, contre les bords de la puce 6. Par exemple, sur la figure 6, les composants 33 + 34 et 35 + 36 sont deux réseaux de filtrage RC.

Un dispositif muni de ces perfectionnements se présente donc comme un micro-boitier à embase métallique, dans lequel le semiconducteur est auto-encapsulé par son substrat, ce micro-boitier portant sur une face externe - constituée par la face 10 du substrat - un circuit électronique et des moyens de connexions externes. Le circuit externe au boîtier est avantageusement protégé par une résine ou un couvercle.

L'invention est préférentiellement appliquée aux dispositifs hyperfréquences : les circuits montés selon l'invention ont des performances supérieures à ceux qui sont montés selon les techniques classiques, par hybridation.

## Revendications

1. Composant semiconducteur de puissance, constitué par une puce semiconductrice (6) et un radiateur thermique (9), le dispositif semiconducteur porté par une première face (7) de la puce (6) comportant au moins une métallisation d'électrode interdigitée à au moins deux doigts, réunis entre eux par au moins un pont métallique (8), dont l'espace d'air le sépare de la première face (7) de la puce semiconductrice (6), dans lequel :
- en vue de transférer la chaleur dégagée en cours de fonctionnement vers le radiateur (9), la puce (6) est brasée à l'envers sur le radiateur (9) par l'intermédiaire d'au moins un pont métallique (8) servant le drain thermique,
- la fixation mécanique de la puce (6) sur le radiateur (9) est en outre assurée par une pluralité de métallisations (17), disposées sur le pourtour de la puce (6), et brasées sur le radiateur (9).

2. Composant de puissance selon la revendication 1, caractérisé en ce que le pont métallique (8) est renforcé par une surépaisseur de métal.

3. Composant de puissance selon la revendication 1, caractérisé en ce que le radiateur (9) porte, dans sa partie centrale (22), une pluralité d'ilôts métalliques en relief (23,24), dont au moins un (23) est en regard d'au moins un pont métallique (8) de la puce semiconductrice (6), et dont les autres (24) sont en regard des métallisations (17) disposées sur le pourtour de la puce (6), qui est brasée sur le radiateur (9) par l'intermédiaire des ilôts (23,24).

4. Composant de puissance selon la revendication 3, caractérisé en ce que les ilôts métalliques (23,24) sont gravés ou estampés dans un radiateur (9) métallique.

5. Composant de puissance selon la revendication 3, caractérisé en ce que les ilôts métalliques (23,24) sont rapportés sur une plaquette (25) en matériau isolant électrique mais conducteur thermique, tel que BeO, AlN ou le diamant, cette plaquette (25) étant brasée sur la partie centrale (22) du radiateur métallique (9).

6. Composant de puissance selon la revendication 3, caractérisé en ce que la radiateur (9) comporte deux pattes de fixation (18,19), latérales qui en font l'embase du dispositif semiconducteur.

7. Composant de puissance selon la revendication 3, caractérisé en ce qu'une métallisation continue (17) sur le pourtour de la puce (6) et un unique ilôt (24) sur le pourtour de la partie centrale (22) du radiateur (9) constituent, après brasage, un microboitier d'encapsulation du dispositif semiconducteur.

8. Composant de puissance selon la revendication 1, caractérisé en ce que, des trous métallisés (11,12,13), à travers le substrat de la puce (6) donnent accès aux électrodes du dispositif, et débouchent sur la deuxième face (10) de la puce (6).

9. Composant de puissance selon la revendication 8, caractérisé en ce qu'un circuit d'interconnexion, des plots de câblage extérieur (26,27,28) et des composants non intégrables (29,30) sont déposés sur la seconde face (10) du substrat de la puce (6).

10. Composant de puissance selon la revendication 9, caractérisé en ce que des composants passifs en pavés (33 à 36) sont déposés sur le radiateur (9), à proximité des bords de la puce (6).

## Patentansprüche

1. Leistungshalbleiterbauelement, das durch einen Halbleiterchip (6) und durch einen Kühlkörper (9) gebildet ist, wobei die Halbleitervorrichtung, die von einer ersten Fläche (7) des Chips (6) getragen wird, wenigstens eine Elektrodenmetallisierung enthält, die in Interdigitation mit wenigstens zwei Zähnen angeordnet ist, welche über wenigstens eine metallische Brücke (8) miteinander vereinigt sind, deren Luftspalt sie von der ersten Fläche (7) des Halbleiterchips (6) trennt, in dem:
- der Chip (6) im Hinblick auf die Beförderung der während des Betriebs freiwerdenden Wärme zum Kühlkörper (9) über wenigstens eine als thermische Senke dienende metallische Brücke (8) seitenverkehrt auf den Kühlkörper (9) gelötet ist,
- die mechanische Befestigung des Chips (6) am Kühlkörper (9) außerdem durch mehrere Metallisierungen (17) gewährleistet ist, die am äußeren Umfang des Chips (6) angeordnet und am Kühlkörper (9) angelötet sind.

2. Leistungshalbleiterbauelement nach Anspruch 1, dadurch gekennzeichnet, daß die metallische Brücke (8) durch eine Überdicke aus Metall verstärkt ist.

3. Leistungshalbleiterbauelement nach Anspruch 1, dadurch gekennzeichnet, daß der Kühlkörper (9) in seinem Mittelteil (22) mehrere reliefartige metallische Inseln (23, 24) trägt, wovon sich wenigstens eine (23) gegenüber wenigstens einer metallischen Brücke (8) des Halbleiterchips (6) befindet und wovon sich die anderen (24) gegenüber den Metallisierungen (17) befinden, die am äußeren Umfang des Chips (6) angeordnet sind, der seinerseits über die Inseln (23, 24) am Kühlkörper (9) angelötet ist.

4. Leistungsbauelement nach Anspruch 3, dadurch gekennzeichnet, daß die metallischen Inseln (23, 24) in einem metallischen Kühlkörper (9) graviert oder geprägt sind.

5. Leistungsbauelement nach Anspruch 3, dadurch gekennzeichnet, daß die metallischen Inseln (23, 24) auf einer Scheibe (25) aus elektrisch isolierendem, jedoch wärmeleitendem Material wie etwa BeO, AlN oder Diamant aufgebracht sind, wobei diese Scheibe (25) auf den Mittelteil (22) des metallischen Kühlkörpers (9) gelötet ist.

6. Leistungsbauelement nach Anspruch 3, dadurch gekennzeichnet, daß der Kühlkörper (9) zwei seitliche Befestigungsansätze (18, 19) enthält, die die Sitzfläche der Halbleitervorrichtung bilden.

7. Leistungsbauelement nach Anspruch 3, dadurch gekennzeichnet, daß eine ununterbrochene Metallisierung (17) auf dem äußeren Umfang des Chips (6) und eine einzige Insel (24) auf dem äußeren Umfang des Mittelteils (22) des Kühlkörpers (9) nach dem Löten ein Mikrogehäuse für die Einkapselung der Halbleitervorrichtung bilden.

8. Leistungsbauelement nach Anspruch 1, dadurch gekennzeichnet, daß metallisierte Löcher (11, 12, 13), die durch das Substrat des Chips (6) verlaufen, einen Zugang zu den Elektroden der Vorrichtung ergeben und in die zweite Fläche (10) des Chips (6) münden.

9. Leistungsbauelement nach Anspruch 8, dadurch gekennzeichnet, daß auf der zweiten Fläche (10) des Substrats des Chips (6) eine Anschlußschaltung, Anschlußflächen für die äußere Verdrahtung (26, 27, 28) sowie nicht integrierbare Bauelemente (29, 30) angebracht sind.

10. Leistungsbauelement nach Anspruch 9, dadurch gekennzeichnet, daß auf dem Kühlkörper (9) in der Nähe der Ränder des Chips (6) klötzchenförmige passive Bauelemente (33 bis 36) aufgebracht sind.

## Claims

1. Semiconductor power component constituted by a semiconductor chip (6) and a thermal radiator (9), the semiconductor device carried by a first face (7) of the chip (6) including at least one electrode metallization interdigitated with at least two fingers joined together by at least one metal bridge (8), the air space of which separates it from the first face (7) of the semiconductor chip (6), in which:
- with the purpose of transferring the heat released during operation to the radiator (9), the chip (6) is brazed upside down to the radiator (9) via at least one metal bridge (8) serving as a heat sink,
- the chip (6) is furthermore mechanically fixed to the radiator (9) by a plurality of metallizations (17) arranged on the perimeter of the chip (6) and brazed to the radiator (9).

2. Power component according to Claim 1, characterized in that the metal bridge (8) is reinforced by an additional thickness of metal.

3. Power component according to Claim 1, characterized in that the radiator (9) carries, in its central part (22), a plurality of small metal islands (23, 24) in relief, at least one (23) of which is facing at least one metal bridge (8) of the semiconductor chip (6) and the others (24) of which face the metallizations (17) arranged on the perimeter of the chip (6) which is brazed to the radiator (9) via the small islands (23, 24).

4. Power component according to Claim 3, characterized in that the small metal islands (23, 24) are etched or stamped in a metal radiator (9).

5. Power component according to Claim 3, characterized in that the small metal islands (23, 24) are attached to a wafer (25) made of a material which is an electrical insulator but a thermal conductor, such as BeO, AlN or diamond, this wafer (25) being brazed to the central part (22) of the metal radiator (9).

6. Power component according to Claim 3, characterized in that the radiator (9) includes two lateral fixing pads (18, 19) which make up the base of the semiconductor device.

7. Power component according to Claim 3, characterized in that a continuous metallization (17) on the perimeter of the chip (6) and a single small island (24) on the perimeter of the central part (22) of the radiator (9) constitute, after brazing, a micropackage for encapsulating the semiconductor device.

8. Power component according to Claim 1, characterized in that plated-through holes (11, 12, 13), through the substrate of the chip (6), give access to the electrodes of the device and emerge on the second face (10) of the chip (6).

9. Power component according to Claim 8, characterized in that an interconnection circuit, external wiring contacts (26, 27, 28) and non-integrable components (29, 30) are arranged on the second face (10) of the substrate of the chip (6).

10. Power component according to Claim 9, characterized in that block-type passive components (33 to 36) are arranged on the radiator (9) in the vicinity of the edges of the chip (6).
